Europäisches Patentamt

European Patent Office

Office européen des brevets

(19)

(11) **EP 0 822 908 B1**

(12) **FASCICULE DE BREVET EUROPEEN**

(45) Date de publication et mention
de la délivrance du brevet:
**02.02.2000 Bulletin 2000/05**

(51) Int Cl.[7]: **B61L 1/20**, H03K 19/007,
G08B 29/16

(21) Numéro de dépôt: **96908938.2**

(22) Date de dépôt: **12.04.1996**

(86) Numéro de dépôt international:
**PCT/BE96/00041**

(87) Numéro de publication internationale:
**WO 96/33087 (24.10.1996 Gazette 1996/47)**

(54) **CELLULE D'ENTREES CONTINUES DESTINEE A DES CIRCUITS D'ACQUISITION D'INFORMATIONS**

GLEICHSPANNUNGSEINGANGSZELLE FÜR INFORMATIONSERFASSUNGSSCHALTUNGEN

DC INPUT CELL FOR DATA ACQUISITION CIRCUITS

(84) Etats contractants désignés:
**AT BE CH DE DK ES FI FR GB GR IE IT LI LU MC NL PT SE**

(30) Priorité: **19.04.1995 EP 95870038**

(43) Date de publication de la demande:
**11.02.1998 Bulletin 1998/07**

(73) Titulaire: **ALSTOM BELGIUM S.A.**
**6001 Charleroi (BE)**

(72) Inventeurs:
• **FRANCKART, Jean-Pierre**
**B-6060 Montignies-sur-Sambre (BE)**

• **HUSSON, Henri**
**B-6224 Wanfercee-Baulet (BE)**
• **MEUNIER, Pierre**
**B-7000 Mons (BE)**

(74) Mandataire: **Van Malderen, Joelle et al**
**Office Van Malderen,**
**Place Reine Fabiola 6/1**
**1083 Bruxelles (BE)**

(56) Documents cités:
**US-A- 4 091 292**

**Description**

**Objet de l'invention.**

La présente invention se rapporte essentiellement à une cellule d'entrées continues destinée à des circuits d'acquisition d'informations, et plus particulièrement en milieu ferroviaire.

**Arrière-plan technologique.**

Actuellement, les cellules pour entrées continues destinées à des circuits d'acquisition d'informations sont essentiellement constituées de relais mécaniques de sécurité qui sont reliés entre eux par de simples câblages.
US-A-4 091 292 divulgue une cellule d'entrées continues selon le préambule de la revendication 1.

**Buts de l'invention.**

La présente invention vise à proposer une cellule pour entrées continues destinée à des circuits d'acquisition d'information et en particulier dans le domaine ferroviaire, qui présente un comportement au moins équivalent au point de vue de la sécurité que celui de l'état de la technique tout en gardant des avantages propres, qui sont un encombrement réduit, une plus grande facilité de maintenance et d'adaptation ainsi qu'une longévité supérieure.
Plus particulièrement, la présente invention vise à proposer une cellule où la lecture par erreur s'effectue toujours dans le sens de la sécurité.
La présente invention vise également à détecter des défaillances qui pourraient se produire dans les différents éléments constitutifs de la cellule.
La présente invention vise en outre à minimiser l'influence de la variation des caractéristiques des composants utilisés sous l'effet d'un facteur extérieur telle qu'une hausse de température, par exemple.

**Principaux éléments caractéristiques de la présente invention.**

La présente invention se rapporte à une cellule d'entrées continues contenant les caractéristiques selon la revendication 1.
Le seuil en tension est réalisé en comparant la tension d'entrée à la tension de référence de la diode zener, tandis que l'isolation galvanique est assurée par les optocoupleurs.
Selon une première forme d'exécution, les deux optocoupleurs comprenant les diodes LED sont disposés en parallèle de telle sorte qu'il y ait un échange d'informations entre les deux chaînes afin de vérifier la cohérence du système.
Selon une autre forme d'exécution préférée, les deux optocoupleurs sont disposés en série en sens inverse, chacun d'entre eux étant mis en parallèle avec une diode, les deux diodes se présentant en sens inverse par rapport à l'optocoupleur correspondant afin de permettre le passage du courant lorsque l'optocoupleur correspondant n'est pas conducteur.
Selon une forme d'exécution encore préférée, chaque diode en parallèle avec un optocoupleur comprenant la diode LED est remplacée par une première résistance, les deux premières résistances présentes dans chacune des chaînes étant rigoureusement identiques.
Selon une forme d'exécution encore préférée, une seconde diode zener est prévue dans chaque chaîne où elle est disposée en parallèle avec la première diode zener suivie de l'optocoupleur faisant fonction d'interrupteur.
Cette seconde diode zener a pour but d'empêcher que la tension inverse de l'une des diodes LED des optocoupleurs n'atteigne sa tension de claquage minimale.
Selon une forme d'exécution encore préférée, une seconde résistance est placée en série avec l'optocoupleur comprenant la diode LED et en parallèle avec la première résistance, les deux secondes résistances présentes dans chacune des chaînes étant également rigoureusement identiques.
Selon une forme d'exécution encore préférée, une des deux chaînes présente un étage tampon à transistor qui permet d'inverser le niveau des impédances de sortie, afin de permettre une détection d'une divergence entre les différentes chaînes de traitement dans le cas où les sorties de plusieurs cellules identiques sont mises en parallèle par des éléments parasites. Dans ce cas, cette configuration permet de détecter une divergence dans le cas où les différentes cellules sont dans des états différents.

**Brève description des figures.**

La présente invention sera décrite plus en détails à l'aide des figures suivantes :

| Les figures 1, 2, 3 et 4 | représentent des schémas de principe qui montrent les éléments essentiels constituant un dispositif selon la présente invention. |
|---|---|
| La figure 5 | représente une forme d'exécution mise en pratique du dispositif selon la présente invention en appliquant les principes décrits dans les figures 1 à 4. |
| Les figures 6 et 8 | représentent des séquences de commandes d'interrupteur et de relecture dans un exemple d'exécution du logiciel scrutant le dispositif selon la présente invention. |
| Les figures 7 et 9 | représentent les organigrammes de traitement des échantillons pour les séquences respectivement données dans les figures 6 et 8. |

## Description d'une forme préférée d'exécution de la présente invention.

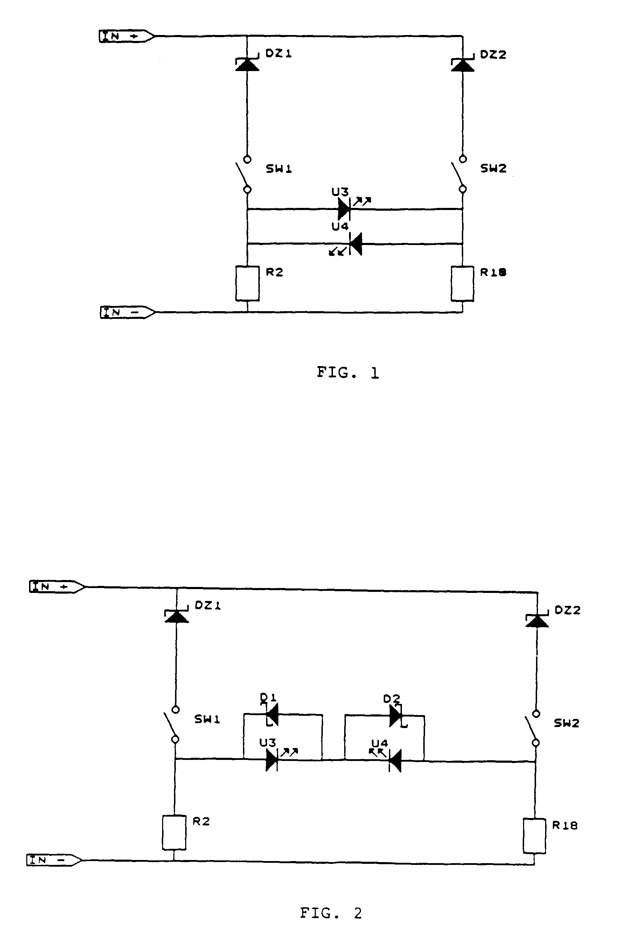

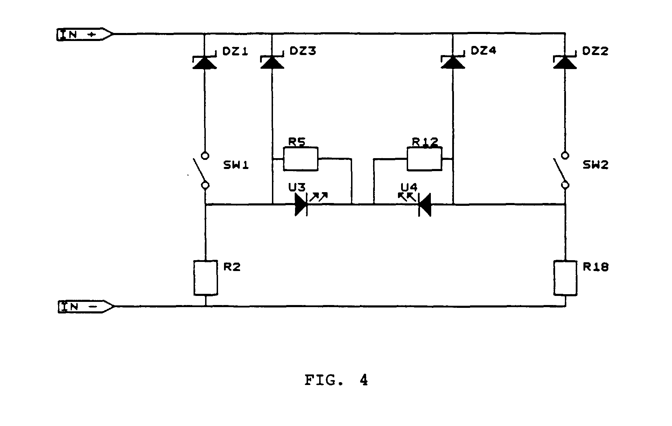

Afin de comprendre les principes qui sous-tendent l'élaboration du dispositif selon la présente invention, on se référera essentiellement aux figures 1, 2, 3 et 4 où sont repris les principaux éléments caractéristiques.

Le dispositif selon la présente invention, appelé communément cellule d'entrées continues tel que représenté à la figure 1, est essentiellement constitué de deux chaînes parallèles d'éléments identiques disposés en série.

La première chaîne, appelée chaîne A, comprend une diode zener DZ1, un interrupteur SW1 qui est de préférence un optocoupleur, un second optocoupleur U3 comprenant une diode LED ainsi qu'une résistance R18, tandis que la seconde chaîne, appelée chaîne B, comprend une diode zener DZ2, un interrupteur SW2 qui est de préférence un optocoupleur, un second optocoupleur U4 comprenant une diode LED ainsi qu'une résistance R2.

Selon cette configuration, ce sont les diodes zeners DZ1 ou DZ2 qui permettent de déterminer le seuil de référence. Le principal inconvénient de ce dispositif réside dans le fait que la consommation garantie au seuil dépend fortement de la sensibilité des optocoupleurs U3 et U4.

C'est dans ce but que l'on a proposé de dédoubler les chaînes d'éléments. Selon la configuration particulière présentée à la figure 1, les deux optocoupleurs U3 et U4 sont disposés en parallèle et en sens inverse, de telle sorte qu'il y ait continuellement un échange d'informations entre les deux chaînes afin de vérifier la cohérence du système.

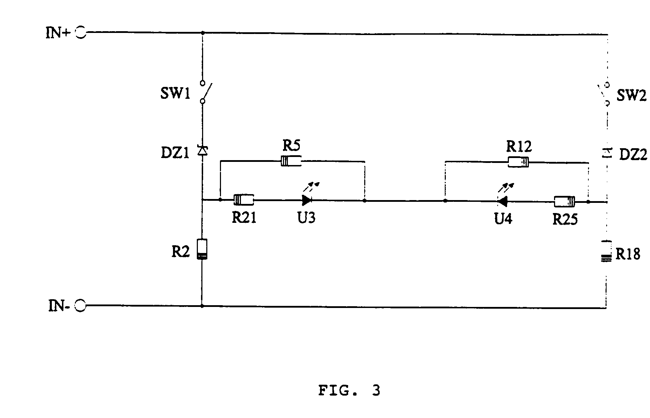

Selon une autre forme d'exécution qui est plus particulièrement représentée à la figure 2, les deux optocoupleurs ne sont plus disposés en parallèle et en sens inverse, mais sont disposés en série et en sens inverse. Dans ce cas, il est bien entendu que l'on a dû disposer une diode en parallèle sur chacun des optocoupleurs U3 et U4. Plus particulièrement, une diode D1 est mise en parallèle avec l'optocoupleur U3 tandis qu'une diode D2 est en parallèle avec l'optocoupleur U4. Il est de nouveau bien entendu que les deux diodes se présentent en sens inverse.

Selon une autre forme d'exécution encore préférée, les diodes D1 et D2 ont été remplacées par des résistances.

En effet, dans le cas d'un schéma comportant des diodes, il convenait de noter qu'il existe une absence de seuil de courant pour l'émission de la diode LED. La diode possède bien un courant d'obscurité, mais qui reste inexploitable.

Ainsi que représenté à la figure 3, en proposant de supprimer les diodes D1 et D2 telles que représentées à la figure 2 et en les remplaçant par des premières résistances rigoureusement identiques R5 et R12, on parvient à garantir une consommation de courant minimale au seuil pour une tension minimale de 1V aux bornes des LED de U3 et U4 lorsque ces derniers commutent. Ceci signifie que pour qu'une diode émette, la tension doit atteindre le seuil de 1V, et le courant passera dans la résistance de la chaîne opposée. De cette manière, il n'y aura pas de tension anormalement élevée.

Les premières résistances R5 et R12 ont donc pour tâche de garantir une consommation de courant minimale au seuil.

Une autre amélioration consiste à prévoir l'ajout de diodes zeners DZ3 et DZ4 en parallèle d'une part avec la diode zener DZ1 et l'interrupteur SW1 et d'autre part avec la diode DZ2 et l'interrupteur SW2. En effet, il convient de noter que la garantie d'une consommation minimale repose sur la présence des résistances R5 et R12, et que l'augmentation de l'une des deux résistances conduit à une augmentation du seuil en tension de la cellule. La coupure totale d'une des résistances R5 ou R12 est normalement détectée par une impossibilité de rendre l'optocoupleur correspondant U3 ou U4 conducteur.

Néanmoins, dans le cas où la tension d'entrée dépasse un certain seuil qui correspond à la tension de claquage minimale de la LED de l'optocoupleur U3 ou U4, il est possible de voir un fonctionnement comme correct dans le cas où la LED de l'optocoupleur sollicité en inverse se met à conduire par claquage.

Le rôle des diodes zeners DZ3 et DZ4 est donc d'empêcher que la tension inverse sur l'une des LED des optocoupleurs U3 et U4 n'atteigne la tension de claquage minimale des LED des optocoupleurs. La présence et la valeur des diodes zeners DZ3 et DZ4 sont contrôlées par les optocoupleurs U3 et U4, pendant les phases de scrutation où SW2 et SW1 sont tous les deux dans l'état ouvert.

Une autre amélioration représentée à la figure 3 consiste à prévoir dans chacune des chaînes A et B la présence d'une seconde résistance en série avec chacun des optocoupleurs U3 ou U4 comprenant la diode LED, étant entendu que ces secondes résistances R21 et R25 sont en parallèle avec les premières résistance R5 et R12. A nouveau, les secondes résistances R21 et R25 sont rigoureusement identiques. La présence de ces secondes résistances permet de s'assurer que la tension inverse qui peut apparaître aux bornes de la LED est toujours inférieure à sa tension de claquage. En effet, si la résistance R12 se coupe, le fonctionnement de la branche de détection pourrait être vu comme normal par les chaînes de traitement si la LED de U2 entre en zone de claquage (en pratique, les tensions inverses supportées par les LEDs d'optocoupleurs sont très faible et dépassent rarement quelques volts).

En prévoyant la présence des secondes résistances R21 et R25 pour la tension maximale d'entrée, on est certain que la tension inverse qui peut apparaître aux bornes de la LED est toujours inférieure à sa tension de claquage.

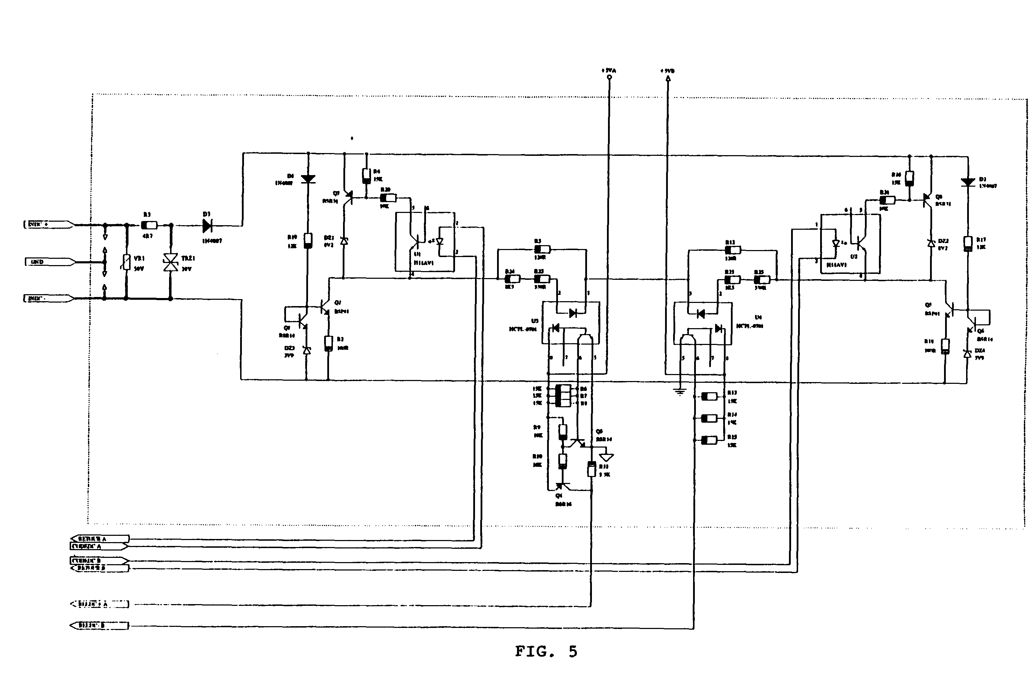

La figure 5 représente un dispositif selon la présente invention mettant en pratique les principes décrits dans les figures précédentes.

Le dispositif décrit à la figure 5 est essentiellement constitué de deux blocs fonctionnels disposés en cascade. Le bloc I assure la protection minimale contre les surtensions et est essentiellement constitué par une résistance R3 qui limite l'amplitude des pointes de courant de décharges éventuelles dans VR1 et un transzorb TRZ1 qui écrête les surtensions apparaissant lors des décharges éventuelles.

Le second bloc (bloc II) réalise essentiellement les fonctions de seuil en tension de la cellule ainsi que l'isolation galvanique entre l'entrée et les sorties des chaînes de traitement telles que expliquées précédemment.

Selon la configuration représentée à la figure 5, les interrupteurs SW1 et SW2 décrits dans les figures précédentes sont dans ce cas-ci des optocoupleurs U1 et U2, tandis que les résistances R18 et R2 ont été remplacées par des injecteurs I1 et I2. L'injecteur I1 est réalisé à l'aide des éléments R17, Q6, Q5, DZ4 et R18, tandis que l'injecteur I2 est constitué des éléments R19, Q1, Q2, DZ3 et R2.

La diode zener DZ1, l'optocoupleur U3 et l'injecteur de courant I1 constituent le premier seuil de référence, tandis que le deuxième seuil de référence est réalisé par la diode zener DZ2, l'optocoupleur U4 et l'injecteur de courant I2.

Les optocoupleurs sont programmés de telle sorte qu'à chaque cycle de scrutation de l'entrée DC, les chaînes de traitement collaborent pour commander U1 et U2 selon la séquence suivante :

|  | U1 | U2 |
|---|---|---|
| étape 1 | "ON" | "OFF" |
| étape 2 | "OFF" | "ON" |
| étape 3 | "ON" | "ON" |
| étape 4 | "OFF" | "OFF" |

A la fin du cycle de scrutation, on laisse alternativement un des deux optocoupleurs U1 ou U2 conducteurs.

A chaque étape du cycle de scrutation, les chaînes de traitement viennent scruter l'état logique sur le collecteur de sortie de U3 et U4.

Les décisions sur l'état de fonctionnement de la cellule et sur l'état logique de la tension d'entrée sont prises comme illustré par les tables ci-dessous :

| CAS 1 |  |  |
|---|---|---|
|  | U3 | U4 |
| étape 1 | "OFF" | "OFF" |
| étape 2 | "OFF" | "OFF" |
| étape 3 | "OFF" | "OFF" |
| étape 4 | "OFF" | "OFF" |

L'entrée est dans l'état logique "0"

| CAS 2 |  |  |
|---|---|---|
|  | U3 | U4 |
| étape 1 | "ON" | "OFF" |
| étape 2 | "OFF" | "ON" |

(suite)

| CAS 2 | | |
|---|---|---|
| | U3 | U4 |
| étape 3 | "OFF" | "OFF" |
| étape 4 | "OFF" | "OFF" |

L'entrée est dans l'état logique "1"

En pratique, le logiciel procède de la façon suivante : une fois par cycle, les processeurs scrutent les entrées pendant 20 ms. Ils prennent 32 échantillons espacés de 625 us. En dehors de cette phase de scrutation, un des interrupteurs est maintenu fermé et l'autre ouvert, afin d'assurer une consommation permanente. La position des interrupteurs alterne à chaque cycle, et chaque chaîne conduit à son tour.

Selon une forme d'exécution préférée, on a prévu deux séquences de scrutation distinctes, où à chaque cycle, les chaînes de traitement changent de séquence de scrutation. Chaque séquence de scrutation est décomposée en deux phases : la première dure 15 ms et la seconde 5 ms. On note :

P = nombre d'échantillons lus à l'état haut à la sortie de l'optocoupleur de la chaîne A (U1) durant la phase de 15 ms;

N = nombre d'échantillons lus à l'état haut à la sortie de l'optocoupleur de la chaîne B (U2) durant la phase de 15 ms;

P' = nombre d'échantillons lus à l'état haut à la sortie de l'optocoupleur de la chaîne A (U1) durant la phase de 5 ms;

N' = nombre d'échantillons lus à l'état haut à la sortie de l'optocoupleur de la chaîne B (U2) durant la phase de 5 ms.

*Séquence 1*

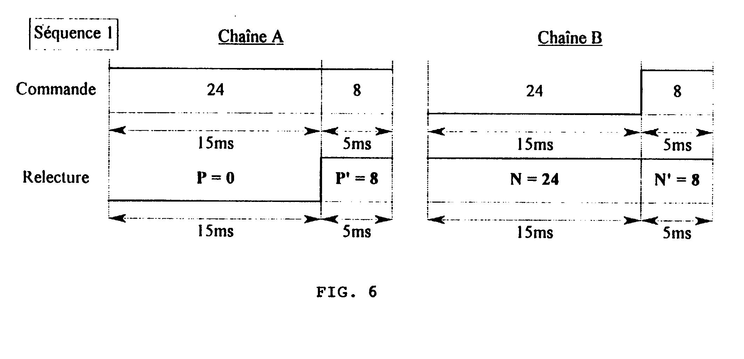

La figure 6 montre les commandes appliquées aux deux interrupteurs ainsi que les relectures en sortie de l'optocoupleur correspondant. Lorsque la commande est à l'état haut, l'interrupteur est fermé. Si la relecture est à l'état bas, l'optocoupleur conduit.

La figure 6 donne, pour chaque phase, le nombre d'échantillons à l'état haut que lisent les chaînes de traitement.

La figure 7 représente l'organigramme de traitement des échantillons pour la séquence 1, dans lequel, durant la phase de 15 ms, seule la chaîne A conduit. Si la tension d'entrée est supérieure au seuil, l'optocoupleur U1 associé à la chaîne A doit conduire pendant toute cette phase. On a donc P = 0 et N = 24. Durant la phase de 5 ms, les deux interrupteurs sont fermés simultanément. Les optocoupleurs ne peuvent conduire. Dans ce cas, P' = N' = 8.

Après chaque séquence de scrutation de 20 ms, sur base du nombre d'échantillons à l'état haut comptés par le microprocesseur, les variables VALEUR et ETAT sont remises à jour. La variable VALEUR indique si la tension appliquée à la cellule est inférieure ou supérieure au seuil :

$$\begin{cases} VALEUR = 0 \rightarrow U_{in} < U_{seuil} \\ VALEUR = 1 \rightarrow U_{in} \geq U_{seuil} \end{cases}$$

La variable ETAT est un indicateur de bon fonctionnement de la cellule d'entrée :

$$\begin{cases} ETAT = 0 \rightarrow \textit{défaut détecté} \\ ETAT = 1 \rightarrow \textit{la cellule fonctionne correctement} \end{cases}$$

La variable binaire dont le logiciel tient compte pour la suite des traitements est VALEUR * ETAT. L'entrée ne peut donc jamais être prise en compte en cas de défaut.

Le signe ? signifie que la variable n'est pas modifiée.

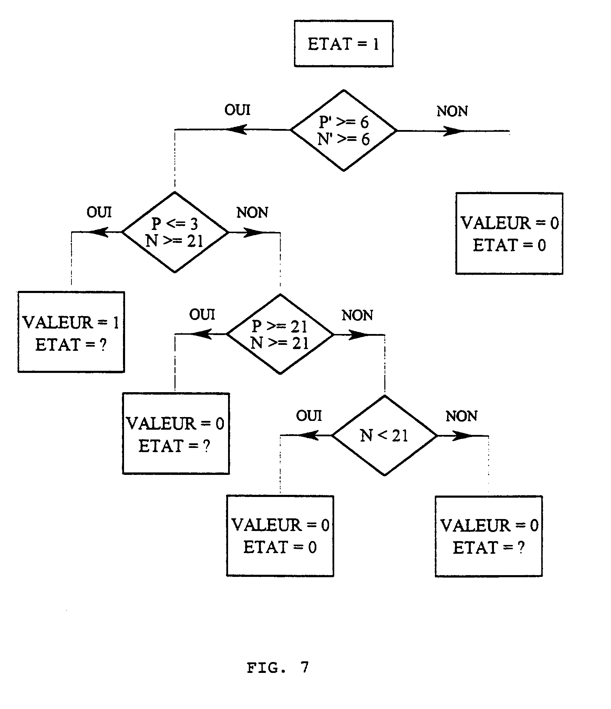

Comme le montre la figure 7, on tolère certains écarts par rapport au nombre idéal d'échantillons. Ces tolérances sont indispensables pour garantir un fonctionnement correct de la cellule en tenant compte du temps de réaction des composants (optocoupleurs, transistors, ...) lors d'un changement de commande des interrupteurs.

*Séquence 2*

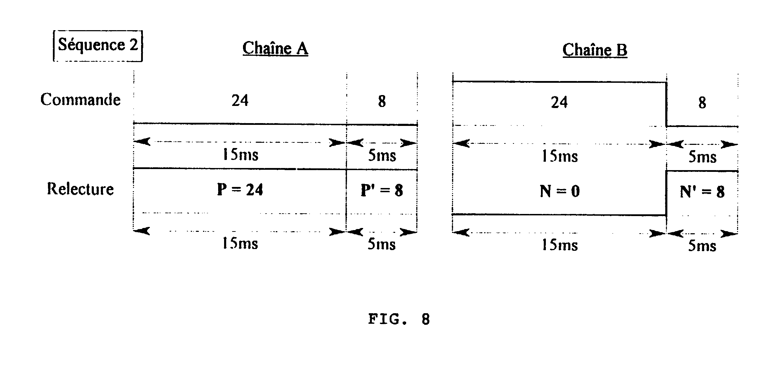

La séquence 2 telle que représentée à la figure 8 est le complément de la séquence 1. Durant les 15 premières millisecondes, seule la chaîne B est commandée. Pendant les 5 dernières millisecondes, les deux chaînes sont coupées.

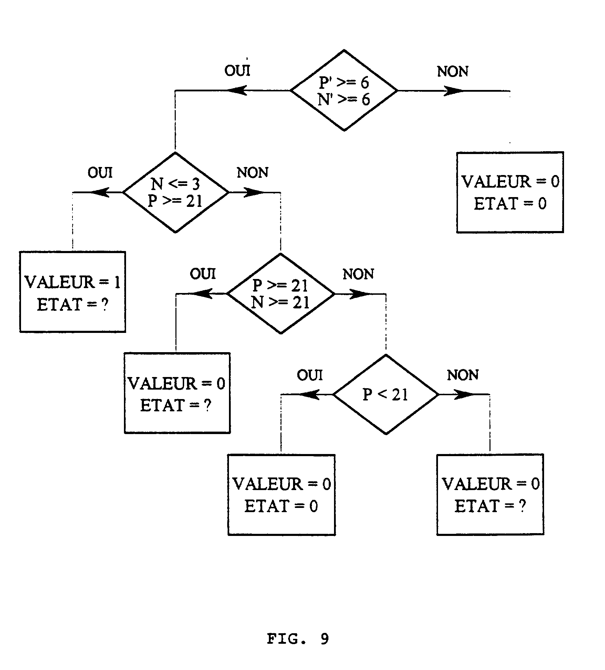

La figure 9 représente l'organigramme de traitement des échantillons.

Pour que le logiciel considère la tension d'entrée supérieure à la tension de seuil, il faut que, durant 4 scrutations successives (séquence 1, séquence 2, séquence 1, séquence 2), le résultat du traitement donne

VALEUR * ETAT = 1.

L'utilisation de telles séquences de scrutation permet de garantir l'insensibilité de la cellule à toute tension alternative de 50 Hz.

Le critère de choix principal pour les deux optocoupleurs U1 et U2 faisant fonction d'interrupteurs est de fonctionner avec un courant de LED le plus faible possible, ce qui permet de garantir un bon fonctionnement en commutation. L'autre critère indispensable pour la sélection des optocoupleurs est d'obtenir une isolation minimale entre l'entrée et la sortie.

Les signaux utiles à la sortie de la cellule se présentent naturellement sur les collecteur des optocoupleurs de sorties avec un niveau d'impédance de sortie élevé pour l'état électrique "1" et un niveau d'impédance faible pour l'état électrique "0". Cette caractéristique présente le risque de pouvoir réaliser sur les deux chaînes de traitement une fonction "OU" logique (du point de vue de l'état des entrées) en cas de défauts consistant en l'apparition de court-circuit entre les signaux de sortie des différentes cellules. Une précaution consiste à utiliser uniquement pour la chaîne de traitement A ainsi que représenté à la figure 5, un étage tampon à transistor inversant le niveau des impédances de sortie de façon telle que l'on a cette fois un niveau d'impédance faible pour l'état électrique "1" et un niveau d'impédance élevé pour l'état électrique "0". Cet étage est constitué par les éléments suivants : R9, Q3, R10, R11 et Q4.

En créant ainsi une dissymétrie entre les deux chaînes A et B, on profite en cas d'apparition de circuits conducteurs parasites multiples, touchant éventuellement les mêmes cellules pour les deux chaînes de traitement, du comportement suivant : l'équivalent d'une fonction OU (au niveau électrique) câblée est réalisée sur les cellules de la chaîne A, tandis que l'équivalent d'un ET (au niveau électrique) câblé est réalisé sur les cellules de la chaîne B.

Ceci conduit à la détection d'une divergence entre chaînes de traitement, dès que les deux cellules concernées par les circuits conducteurs parasites se trouvent dans des états différents.


**Revendications**

**1.** Cellule d'entrées continues de scrutation d'une tension d'entrée continue et destinée à des circuits d'acquisition d'informations, en particulier dans le domaine ferroviaire, comprenant deux chaînes d'éléments identiques , les deux chaînes étant reliées en parallèle entre les entrées continues, chaque chaîne d'éléments comprenant au moins une diode zener (DZ1, DZ2) et un élément résistif (R2, R18), les deux chaînes étant reliées entre elles par deux optocoupleurs (U3, U4) comprenant chacun une diode LED reliés aux points respectifs entre les éléments résistifs (R2, R18) et les diodes zener (DZ1,DZ2), caractérisée en ce que chaque chaîne comprend un interrupteur (SW1, SW2), constitué de préférence par un optocoupleur (U1, U2), relié en série avec la diode zener respective (DZ1,DZ2).

**2.** Cellule selon la revendication 1, caractérisée en ce que les deux optocoupleurs (U3, U4) comprenant les diodes LED sont disposés en parallèle en sens inverse.

**3.** Cellule selon la revendication 1, caractérisée en ce que les deux optocoupleurs (U3, U4) comprenant les diodes LED sont disposés en série en sens inverse, chacun des deux optocoupleurs (U3, U4) étant mis en parallèle avec une diode (D1, D2).

**4.** Cellule selon la revendication 1, caractérisée en ce que les deux optocoupleurs (U3, U4) comprenant les diodes LED sont disposés en série en sens inverse, chacune des LED des deux optocoupleurs (U3, U4) étant mise en parallèle avec une première résistance (R5, R12).

**5.** Cellule selon la revendication 4, caractérisée en ce qu'une seconde résistance (R21, R25) est mise en série avec chacun des optocoupleurs (U3, U4) comprenant les diodes LED, les branches de ces secondes résistances et les optocoupleurs (U3, U4) comprenant les diodes LED étant en parallèle avec les premières résistances (R5, R12).

**6.** Cellule selon l'une quelconque des revendications 1 à 4, caractérisée en ce qu'une seconde diode zener (DZ3, DZ4) est présente dans chacune des chaînes en parallèle avec la diode zener (DZ1, DZ2) suivie de l'interrupteur (SW1, SW2).

7. Cellule selon l'une quelconque des revendications précédentes, caractérisée en ce qu'elle comprend sur une seule des chaînes (A) un étage tampon à transistor (R9, Q3, R10, R11 et Q4) inversant le niveau de l'impédance de sortie, de l'optocoupleur (U3) comprenant la diode LED.

## Claims

1. DC input cell for scanning a DC input voltage and intended for data acquisition circuits, particularly for railway applications, comprising two lines of identical elements, the two lines being connected in parallel between the DC inputs, each line of elements comprising at least one Zener diode (DZ1, DZ2) and one resistive element (R2, R18), the two lines being connected by two optocouplers (U3, U4), each comprising a LED diode, connected to the respective points between the resistive elements (R2, R18) and the Zener diodes (DZ1, DZ2), characterized in that each line comprises a switch (SW1, SW2), preferably consisting of an optocoupler (U1, U2), connected in series with the respective Zener diode (DZ1, DZ2).

2. Cell according to Claim 1, characterized in that the two optocouplers (U3, U4) comprising the LED diodes are arranged in parallel in opposite directions.

3. Cell according to Claim 1, characterized in that the two optocouplers (U3, U4) comprising the LED diodes are arranged in series in opposite directions, each of the two optocouplers (U3, U4) being arranged in parallel with a diode (D1, D2).

4. Cell according to Claim 1, characterized in that the two optocouplers (U3, U4) comprising the LED diodes are arranged in series in opposite directions, each of the LEDs of the two optocouplers (U3, U4) being arranged in parallel with a first resistor (R5, R12).

5. Cell according to claim 4, characterized in that a second Zener diode (R21, R25) is arranged in series with each of the optocouplers (U3, U4) comprising the LED diodes, the branches of these second resistors and the optocouplers (U3, U4) comprising the LED diodes being in parallel with the first resistors (R5, R12).

6. Cell according to any one Claims 1 to 4, characterized in that a second Zener diode (DZ3, DZ4) is present in each of the lines in parallel with the Zener diode (DZ1, DZ2) followed by the switch (SW1, SW2).

7. Cell according to any one of the preceding claims, characterized in that, on just one of the lines (A) it comprises a buffer stage with transistor (R9, Q3, R10, R11 and Q4) inverting the level of the output impedance of the optocoupler (U3) comprising the LED diode.

## Patentansprüche

1. Eingangsgleichspannungs-Zelle zum Abfragen einer Eingangsgleichspannung, für Informationserfassungsschaltungen, insbesondere auf dem Gebiet der Eisenbahn, aufweisend zwei Ketten von identischen Elementen, wobei die zwei Ketten zwischen den Gleichspannungseingängen parallel miteinander verbunden sind, jede Kette von Elementen mindestens eine Zenerdiode (DZ1, DZ2) und ein Widerstandselement (R2, R18) aufweist, und die zwei Ketten bei den jeweiligen Punkten zwischen den Widerstandselementen (R2, R18) und den Zenerdioden (DZ1, DZ2) über zwei Optokoppler (U3, U4), von denen jeder eine LED-Diode aufweist, miteinander verbunden sind, dadurch gekennzeichnet, daß jede Kette einen vorzugsweise aus einem Optokoppler (U1, U2) bestehenden Schalter (SW1, SW2) aufweist, der in Serie mit der jeweiligen Zenerdiode (DZ1, DZ2) angeschlossen ist.

2. Zelle gemäß Anspruch 1, dadurch gekennzeichnet, daß die zwei Optokoppler (U3, U4), die die LED-Dioden aufweisen, parallel zueinander angeordnet sind und entgegengesetzt gerichtet sind.

3. Zelle gemäß Anspruch 1, dadurch gekennzeichnet, daß die zwei Optokoppler (U3, U4), die die LED-Dioden aufweisen, in Serie angeordnet sind und entgegengesetzt gerichtet sind, wobei jeder der zwei Optokoppler (U3, U4) parallel zu einer Diode (D1, D2) gelegt ist.

4. Zelle gemäß Anspruch 1, dadurch gekennzeichnet, daß die zwei Optokoppler (U3, U4), die die LED-Dioden aufweisen, in Serie angeordnet sind und entgegengesetzt gerichtet sind, wobei jede der LED-Dioden der zwei Optokoppler (U3, U4) parallel zu einem ersten Widerstand (R5, R12) gelegt ist.

5. Zelle gemäß Anspruch 4, dadurch gekennzeichnet, daß ein zweiter Widerstand (R21, R25) in Serie zu jedem der die LED-Dioden aufweisenden Optokoppler (U3, U4) gelegt ist, wobei die Zweige aus diesen zweiten Widerständen und den die LED-Dioden aufweisenden Optokopplern (U3, U4) parallel zu den ersten Widerständen (R5, R12) angeordnet sind.

6. Zelle gemäß irgendeinem der Ansprüche 1 bis 4, dadurch gekennzeichnet, daß eine zweite Zenerdiode (DZ3, DZ4) bei jeder der Ketten parallel zu der Serienanordnung aus der Zenerdiode (DZ1, DZ2) und dem Schalter (SW1, SW2) angeschlossen ist.

7. Zelle gemäß irgendeinem der vorhergehenden Ansprüche, dadurch gekennzeichnet, daß sie bei einer einzigen der Ketten (A) eine Transistor-Pufferstufe (R9, Q3, R10, R11 und Q4) aufweist, die das Niveau der Ausgangsimpedanz des eine LED-Diode aufweisenden Optokopplers (U3) umkehrt.

FIG. 1

FIG. 2

FIG. 3

FIG. 4

FIG. 5

EP 0 822 908 B1

Séquence 1

**Chaîne A**

**Chaîne B**

Commande

| 24 | 8 |

| 24 | 8 |

15ms   5ms

15ms   5ms

Relecture

| P = 0 | P' = 8 |

| N = 24 | N' = 8 |

15ms   5ms

15ms   5ms

FIG. 6

FIG. 7

| Séquence 2 | Chaîne A | | Chaîne B | |
|---|---|---|---|---|
| Commande | 24 | 8 | 24 | 8 |
| | 15ms | 5ms | 15ms | 5ms |
| Relecture | P = 24 | P' = 8 | N = 0 | N' = 8 |
| | 15ms | 5ms | 15ms | 5ms |

FIG. 8

OUI     P' >= 6    NON
N' >= 6

VALEUR = 0
ETAT = 0

OUI    N <= 3    NON
P >= 21

VALEUR = 1
ETAT = ?

OUI    P >= 21    NON
N >= 21

VALEUR = 0
ETAT = ?

OUI    P < 21    NON

VALEUR = 0
ETAT = 0

VALEUR = 0
ETAT = ?

FIG. 9